# EUROPÄISCHE PATENTANMELDUNG

(11) **EP 1 531 090 A1**
(43) Veröffentlichungstag der Anmeldung: **18.05.2005**
(21) Anmeldenummer: 04027279.1
(22) Anmeldetag: 17.11.2004
(51) Int. Cl.: B60R 11/02

(54) **Halterung zur Montage von elektronischen Einheiten**

(30) Priorität: 17.11.2003 DE 20317763 U
(71) Anmelder: Bisplinghoff, Gisela, 33758 Schloss Holte-Stuckenbrock (DE)
(72) Erfinder: Bisplinghoff, Gisela, 33758 Schloss Holte-Stuckenbrock (DE)
(74) Vertreter: Specht, Peter, Dipl.-Phys.

(57) **Zusammenfassung**

Eine Halterung dient zur Montage von elektronischen Einheiten (12) an einem Armaturenbrett (5) in einem Fahrzeug, insbesondere von elektronischen Einheiten (12) zur Wegerfassung, und umfasst einen Formkörper (2), der mit einer Anlagefläche (3) im wesentlichen formschlüssig an ein Armaturenbrett (5) eines Fahrzeuges montierbar ist, wobei an der gegenüberliegenden Seite der Anlagefläche (3) eine ebene Montagefläche (4) ausgebildet ist, die im montierten Zustand zur Windschutzscheibe hin geneigt ausgebildet ist. Dadurch kann bei der Montage der Halterung eine großflächige Anlagefläche ausgebildet sein, die auch bei starken Vibrationen noch einen sicheren Halt gewährleistet. Die Anlagefläche (3) ermöglicht dabei im montierten Zustand mit dem Formkörper (2) eine definierte Position der elektronischen Einheit in dem Fahrzeug vorzusehen.

## Beschreibung

Die vorliegende Erfindung betrifft eine Halterung zur Montage von elektronischen Einheiten an einem Armaturenbrett in einem Fahrzeug, insbesondere von elektronischen Einheiten zur Wegerfassung.

Bei der Montage von elektronischen Einheiten an einem Armaturenbrett eines Fahrzeuges ergibt sich das Problem, dass einfache Schraubverbindungen häufig nur einen unzureichenden Halt geben, da ständig Vibrationen auf das Fahrzeug einwirken und somit hohe Belastungen für die jeweiligen mechanischen Verbindungsmittel vorhanden sind. Es besteht daher ein Bedarf, eine dauerhafte Verbindung am Armaturenbrett zu schaffen, die auch erheblichen mechanischen Belastungen standhält. Zudem kann gerade bei elektronischen Einheiten mit Sende- und Empfangsfunktion der Bedarf bestehen, dass eine besondere Ausrichtung der Einheit erforderlich ist, um die Störanfälligkeit des Geräts zu minimieren. Übliche Befestigungsmittel bieten keine Möglichkeit zur Verstellung und es besteht das Problem, dass die Armaturenbretter von Fahrzeugen, insbesondere LKW, eine andere Kontur besitzen können, sodass die Anordnung der Elektronikeinheit variieren kann. Schließlich muss gewährleistet sein, dass solche Elektronikeinheiten, insbesondere bei der Verfassung für den Maut, leicht zu montieren sind, da es sich um Massenprodukte handelt.

Es ist daher Aufgabe der vorliegenden Erfindung, eine Halterung zur Montage von elektronischen Einheiten an einem Armaturenbrett in einem Fahrzeug zu schaffen, die die obengenannten Probleme löst und insbesondere leicht zu montieren ist und einen dauerhaften Halt der elektronischen Einheit an dem Armaturenbrett gewährleistet.

Diese Aufgabe wird mit einer Halterung zur Montage von elektronischen Einheiten mit den Merkmalen des Anspruches 1 gelöst.

Erfindungsgemäß weist die Halterung einen Formkörper auf, der mit einer Anlagefläche im Wesentlichen formschlüssig an ein Armaturenbrett eines Fahrzeuges montierbar ist. Dadurch kann bei der Montage der Halterung eine großflächige Anlagefläche ausgebildet sein, die auch bei starken Vibrationen noch einen sicheren Halt gewährleistet. Die entsprechenden mechanischen Befestigungsmittel, wie Schrauben, werden dadurch weniger stark beansprucht. Zur Montage der elektronischen Einheit ist an der gegenüberliegenden Seite der Anlagefläche eine ebene Montagefläche ausgebildet, die im montierten Zustand zur Windschutzscheibe hin geneigt ausgebildet ist. Dadurch wird mit dem Formkörper eine definierte Position der elektronischen Einheit in dem Fahrzeug vorgesehen. Der Formkörper gewährleistet dabei, dass dieser an einer bestimmten Stelle des Armaturenbrettes mit einer bestimmten Neigung montiert wird, sodass keine nachträgliche Einstellung der Neigung bzw. Position mehr erfolgen muss. Der Formkörper gibt die Montageposition für die elektronische Einheit demnach vor.

Vorzugsweise ist die Montagefläche in einem Winkel zur Horizontalen von 15-25° vorzugsweise etwa 20° zur Scheibe hin geneigt ausgebildet. Dadurch wird gewährleistet, dass die elektronische Einheit gut positioniert ist und auch entsprechende Sende- und Empfangseinrichtungen entsprechend ausgerichtet werden können.

Für eine stabile Ausbildung des Formkörpers ist vorzugsweise ein plattenförmiges Verstärkungselement zu der Anlagefläche in dem Formkörper angeordnet.

Das Verstärkungselement steht vorzugsweise zumindest an einer Seite über den Formkörper hervor, sodass an diesem Abschnitt mechanische Befestigungsmittel angeordnet werden können. Beispielsweise kann an dem hervorstehenden Abschnitt mindestens eine Öffnung zur Verschraubung mit dem Fahrzeug ausgespart sein. Es ist auch möglich, mehrere hervorstehende Abschnitte aus dem Formkörper heraustreten zu lassen, die dann verschraubt oder anderweitig befestigt werden. Ferner ist es möglich, an dem hervorstehenden Abschnitt Haken auszubilden, die dann in einen Lüftungsschlitz des Fahrzeuges einfügbar sind. An den Haken können dann wiederum Öffnungen zum Verschrauben ausgebildet sein, sodass nach der Montage der Halterung die Befestigungsmittel in einem nicht sichtbaren Bereich liegen.

Für eine kostengünstige Herstellung der Halterung ist das plattenförmige Verstärkungselement aus einem gebogenen und gestanzten Blechteil hergestellt, das von dem Formkörper dann umgeben ist.

Für eine einfache Montage der elektronischen Einheit sind in der Montagefläche Öffnungen zum Verschrauben einer Befestigungsplatte der elektronischen Einheit vorgesehen. Dann kann nach Montage der Halterung an dem Fahrzeug die elektronische Einheit auf einfache Weise montiert werden, wenn die Platte an den dafür vorgesehenen Öffnungen verschraubt wird und dann die elektronische Einheit auf die Befestigungsplatte aufgeschoben wird. Nach dem Aufschieben kann die elektronische Einheit dann über weitere Befestigungsmittel gesichert werden.

Um die Zuleitungen zu der elektronischen Einheit in einem nicht sichtbaren Bereich anzuordnen, kann im Bereich der Anlagefläche ein Kabelkanal ausgespart sein. Dies ermöglicht das Einfügen der notwendigen Zuleitungen an der Rückseite der Halterung, sodass die Zuleitungen nicht versehentlich beschädigt werden können.

Der Formkörper besteht vorzugsweise aus einem Zwei-Komponentenschaum, beispielsweise aus Polyurethanschaum. Dabei weist der Formkörper eine gewisse Elastizität auf, die besonders gut den Vibrationen in einem Fahrzeug standhält. Ferner kann der Formkörper dann bei Bedarf auch gut nachträglich bearbeitet werden, beispielsweise können Bohrungen oder andere Verformungen noch eingebracht werden.

Für ein optisch ansprechendes Erscheinungsbild ist die Oberfläche des Formkörpers mit lederartigen Riefen versehen, sodass sich die Halterung formschön an ein Armaturenbrett eines Fahrzeuges angliedert.

Die Erfindung wird nachfolgend anhand mehrerer Ausführungsbeispiele mit Bezug auf die beigefügten Zeichnungen näher erläutert. Es zeigen:
- Figur 1: eine perspektivische Explosionsdarstellung einer erfindungsgemäßen Halterung nach der Montage;
- Figur 2: eine perspektivische Detailansicht der Halterung der Figur 1;
- Figur 3: eine perspektivische Ansicht der Halterung der Figur 1;
- Figur 4: eine Unteransicht der Halterung der Figur 1;
- Figur 5: eine perspektivische Ansicht einer Halterung gemäß einem zweiten Ausführungsbeispiel, und
- Figur 6: eine Detailansicht der Befestigungsplatte für eine erfindungsgemäße Halterung.

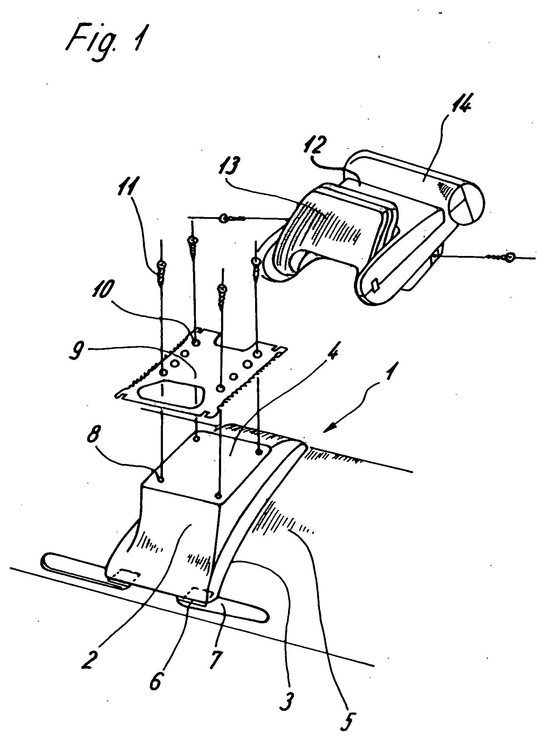

Eine Halterung 1 weist einen Formkörper aus einem geschäumten Kunststoff, beispielsweise aus Polyurethan auf, der an der unteren Seite eine Anlagefläche 3 ausbildet und an der oberen Seite eine Montagefläche 4 aufweist. Die Anlagefläche 3 ist gekrümmt ausgebildet und an die Kontur eines Armaturenbrettes eines Fahrzeuges, wie einem LKW, angepasst. In dem Formkörper 2 ist ein Verstärkungselement in Form eines gebogenen und ausgestanzten Bleches angeordnet, das benachbart zu der Anlagefläche 3 positioniert ist. Das Verstärkungselement steht an gegenüberliegenden Seiten an dem Formkörper 2 hervor, wobei die hervorstehenden Abschnitte 6 zur mechanischen Festlegung der Halterung 1 dienen. In Figur 1 stehen zwei hervorstehende Abschnitte 6 jeweils in einen Lüftungsschlitz 7 des Fahrzeuges hinein und können dort verschraubt oder anderweitig festgelegt sein. Die Befestigungsmittel sind somit nicht mehr in einem sichtbaren Bereich.

Die Montagefläche 4 ist eben ausgebildet und gegenüber der Horizontalen zur Windschutzscheibe geneigt, vorzugsweise in einem Winkel von 15-25°. An der Montagefläche 4 sind vier Öffnungen 8 ausgespart, in die Schrauben 11 eingedreht werden können. Die Öffnungen 8 sind dabei geringer als der Durchmesser der Schrauben 11 ausgebildet, sodass die Schrauben 11 klemmend in dem Formkörper 2 festlegbar sind. An der Montagefläche 4 wird eine Befestigungsplatte 9 für eine elektronische Einheit 12 montiert. Die Befestigungsplatte 9 weist mehrere Öffnungen 10 auf, in die dann Schrauben 11 einfügbar sind. Auf die Befestigungsplatte 9 kann dann die elektronische Einheit 12 aufgeschoben werden und über weitere Schrauben an der Befestigungsplatte 9 fixiert werden. Die elektronische Einheit 12 weist eine Sende- und Empfangseinheit 13 auf, die benachbart zu der Windschutzscheibe angeordnet ist. Auf der gegenüberliegenden Seite der elektronischen Einheit ist ein Bedienteil 14 montiert, das zum Fahrer gerichtet ist.

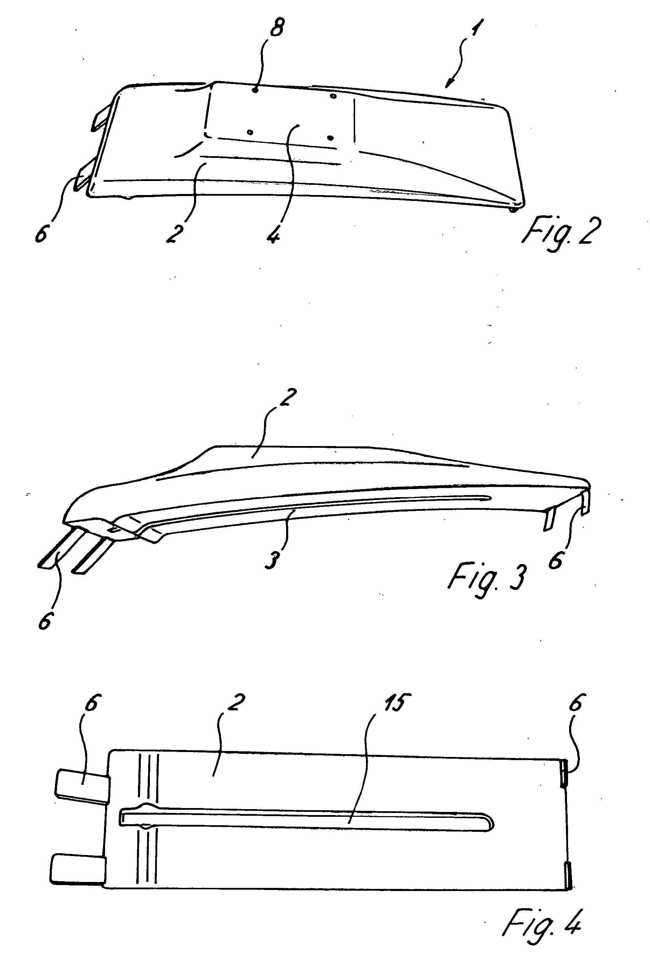

In den Figuren 2 bis 4 ist die erfindungsgemäße Halterung 1 im Detail dargestellt. Wie gut zu sehen ist, weist der Formkörper an der Anlagefläche 3 eine Krümmung auf, die an die Krümmung des Armaturenbrettes 5 des Fahrzeuges angepasst ist. Für jeden unterschiedlichen Fahrzeugtyp wird daher eine eigene Halterung 1 bereitgestellt, die entsprechende Befestigungsmittel aufweist. Die Vorteile durch die einfache Montage der Halterung 1 überwiegen den Aufwand für die Herstellung unterschiedlicher Typen von Halterungen1.

Die gezeigte Halterung 1 weist an gegenüberliegenden Seiten hervorstehende Abschnitte 6 auf, an denen Öffnungen ausgespart sein können, damit entsprechende Schrauben montiert werden können. Alternativ können die hervorstehenden Abschnitte 6 auch als Anlagehaken dienen, sofern an dem Armaturenbrett 5 eine entsprechende Rille ausgebildet ist.

In der Unterseite des Formkörpers 2 ist ein Kabelkanal 15 ausgespart, der sich im wesentlichen über die gesamte Länge des Formkörpers 2 erstreckt. Im Endbereich endet der Kabelkanal 15, kann jedoch bei Bedarf auf einfache Weise verlängert werden, indem entsprechende Schnitte mit dem Messer Material des Formkörpers 2 entfernen. Alternativ kann sich der Kabelkanal 15 auch über die gesamte Länge des Formkörpers 2 erstrecken, ist jedoch dann in jedem Fall sichtbar.

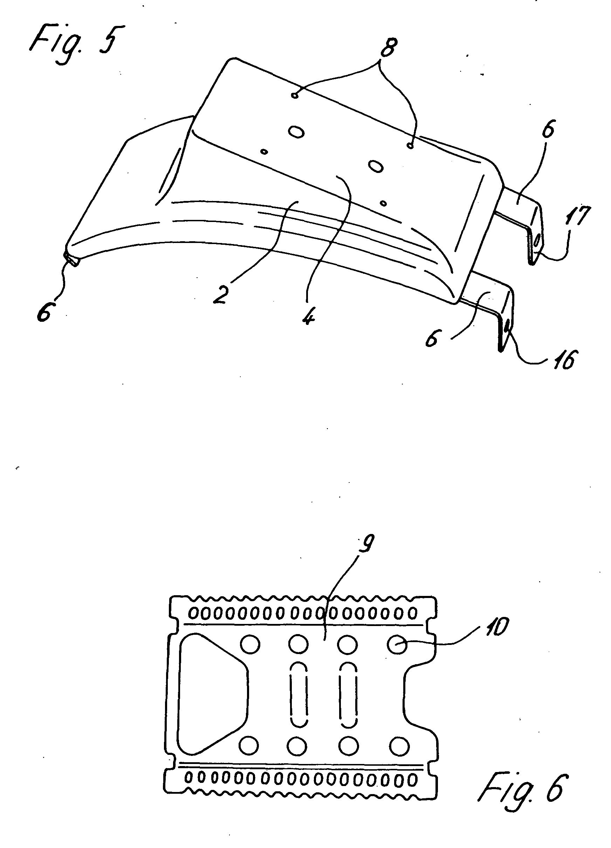

Bei dem in Figur 5 gezeigten Ausführungsbeispiel einer Halterung ist der Formkörper 2 mit einer anderen Krümmung im Bereich der Anlagefläche 3 ausgerüstet. Ferner ist die Ebene Montagefläche 4 etwas modifiziert worden, wobei diese Halterung dann für einen anderen Fahrzeugtyp einsetzbar ist. Gut zu erkennen sind die hervorstehenden Abschnitte 6 der Verstärkungsplatte, die an einer Seite hakenförmig ausgebildet sind, wobei ein hakenförmiger Teil 17 mit einer Öffnung 16 versehen ist, in die dann Befestigungsmittel einfügbar sind. Der hakenförmige Teil 17 lässt sich besonders gut in die Lüftungsschlitze 7 eines Fahrzeuges einfügen.

In Figur 6 ist die gezeigte Befestigungsplatte 9 im Detail dargestellt, die aus Metall besteht und mehrere Öffnungen 10 zur Verbindung mit Schrauben 11 aufweist.

Die Erfindung ist nicht auf die dargestellten Ausführungsbeispiele beschränkt. Insbesondere kann die Kontur des Formkörpers 2 entsprechend der Geometrie des jeweiligen Armaturenbrettes 5 angepasst sein. Auch die Art der Befestigung mit en hervorstehenden Abschnitten 6 kann in weiten Bereichen modifiziert werden.

## Patentansprüche

1. Halterung zur Montage von elektronischen Einheiten (12) an einem Armaturenbrett (5) in einem Fahrzeug, insbesondere von elektronischen Einheiten (12) zur Wegerfassung, mit einem Formkörper (2), der mit einer Anlagefläche (3) im wesentlichen formschlüssig an ein Armaturenbrett (5) eines Fahrzeuges montierbar ist, wobei an der gegenüberliegenden Seite der Anlagefläche (3) eine ebene Montagefläche (4) ausgebildet ist, die im montierten Zustand zur Windschutzscheibe hin geneigt ausgebildet ist.

2. Halterung nach Anspruch 1, **dadurch gekennzeichnet, dass** die Montagefläche (4) in einem Winkel zur Horizontalen von 15° bis 25°, vorzugsweise etwa 20° zur Windschutzscheibe hin geneigt ausgebildet ist.

3. Halterung nach Anspruch 1 oder 2, **dadurch gekennzeichnet, dass** ein plattenförmiges Verstärkungselement benachbart zu der Anlagefläche (3) in dem Formkörper (2) angeordnet ist.

4. Halterung nach einem der Ansprüche 1 bis 3, **dadurch gekennzeichnet, dass** das Verstärkungselement zumindest an einer Seite über den Formkörper (2) hervorsteht.

5. Halterung nach Anspruch 4, **dadurch gekennzeichnet, dass** an dem hervorstehenden Abschnitt (6) des Verstärkungselementes mindestens eine Öffnung (16) zur Verschraubung mit dem Fahrzeug ausgespart ist.

6. Halterung nach Anspruch 4 oder 5, **dadurch gekennzeichnet, dass** der hervorstehende Abschnitt (6) hakenförmig ausgebildet ist.

7. Halterung nach Anspruch 6, **dadurch gekennzeichnet, dass** der hakenförmige Teil (17) des hervorstehenden Abschnittes (6) in einen Lüftungsschlitz (7) des Fahrzeuges einfügbar ist.

8. Halterung nach einem der Ansprüche 1 bis 7, **dadurch gekennzeichnet, dass** das plattenförmige Verstärkungselement aus einem gebogenen und gestanzten Blechteil hergestellt ist.

9. Halterung nach einem der Ansprüche 1 bis 8, **dadurch gekennzeichnet, dass** in der Montagefläche (4) Öffnungen (8) zum Verschrauben einer Befestigungsplatte (9) der elektronischen Einheit (12) vorgesehen sind.

10. Halterung nach einem der Ansprüche 1 bis 9, **dadurch gekennzeichnet, dass** an der Anlagefläche (3) des Formkörpers (2) ein Kabelkanal (15) ausgespart ist.

11. Halterung nach einem der Ansprüche 1 bis 10, **dadurch gekennzeichnet, dass** der Formkörper (2) aus einem Zwei-Komponentenschaum, vorzugsweise aus einem Polyurethanschaum hergestellt ist.

12. Halterung nach einem der Ansprüche 1 bis 11, **dadurch gekennzeichnet, dass** die Oberfläche des Formkörpers (2) mit lederartigen Riefen versehen ist.
